# EUROPÄISCHE PATENTSCHRIFT

(11) **EP 2 837 042 B1**
(45) Veröffentlichungstag und Bekanntmachung des Hinweises auf die Patenterteilung: **25.05.2016**
(21) Anmeldenummer: 13715222.9
(22) Anmeldetag: 10.04.2013
(51) Int. Cl.: H01L 35/32, F01N 5/02, F28F 9/00, H01L 35/30

(54) **THERMOELEKTRISCHER GENERATOR MIT WÄRMETAUSCHER**
THERMOELECTRIC GENERATOR COMPRISING HEAT EXCHANGER
GÉNÉRATEUR THERMOÉLECTRIQUE COMPRENANT UN ÉCHANGEUR DE CHALEUR

(30) Priorität: 13.04.2012 DE 102012206085
(43) Veröffentlichungstag der Anmeldung: 18.02.2015
(73) Patentinhaber: Eberspächer Exhaust Technology GmbH & Co. KG, 66539 Neunkirchen (DE)
(72) Erfinder: RESCH, Andreas, 71032 Böblingen (DE); LEICHT, Sebastian, 72406 Bisingen (DE); OESTERLE, Jörg, 89150 Laichingen (DE)
(74) Vertreter: BRP Renaud & Partner mbB Rechtsanwälte Patentanwälte Steuerberater
(86) Internationale Anmeldenummer: PCT/EP2013/057458
(87) Internationale Veröffentlichungsnummer: WO 2013/153095

(56) Entgegenhaltungen:
- EP-A2- 1 580 819
- EP-A2- 2 378 578
- DE-A1-102006 019 282
- DE-A1-102008 055 946
- DE-B3-102010 063 460
- US-A- 3 197 342

## Beschreibung

Die vorliegende Erfindung betrifft einen Wärmetauscher, insbesondere für eine Abgasanlage einer Brennkraftmaschine, vorzugsweise in einem Kraftfahrzeug. Die vorliegende Erfindung betrifft außerdem eine Brennkraftmaschine, insbesondere in einem Kraftfahrzeug, die mit wenigstens einem solchen Wärmetauscher ausgestattet ist.

Um den energetischen Wirkungsgrad von Brennkraftmaschinen, insbesondere bei Fahrzeuganwendungen, zu verbessern, ist es möglich, Wärmeenergie, die im Abgas der Brennkraftmaschine enthalten ist, zu nutzen. Beispielsweise kann mit Hilfe thermoelektrischer Generatoren die im Abgas enthaltene Wärme in elektrische Energie gewandelt werden. Hierzu kommen Wärmetauscher der eingangs genannten Art zum Einsatz, die zumindest einen thermoelektrischen Generator umfassen, der eine Heißseite und eine Kaltseite besitzt. Zusätzlich oder alternativ können zur Nutzung der im Abgas enthaltenen Wärmeenergie Wärmetauscher zur Anwendung kommen, um die Wärme aus dem Abgas, das dann als Heizmittel dient, in ein Kühlmittel zu übertragen, bspw. um damit einen Fahrgastinnenraum zu beheizen oder um das Kühlmittel, das dann als Arbeitsmittel dient, innerhalb eines Rankine-Kreisprozesses zu verdampfen. Ein Wärmetauscher, der zumindest einen thermoelektrischen Generator aufweist, umfasst des Weiteren zumindest ein Heizrohr zum Führen eines Heizmittels, das an wenigstens einer Heißseite eines solchen thermoelektrischen Generators angeordnet ist, sowie mindestens ein Kühlrohr zum Führen eines Kühlmittels, das an wenigstens einer Kaltseite eines solchen thermoelektrischen Generators angeordnet ist. Zweckmäßig kann dabei vorgesehen sein, dass innerhalb des Wärmetauschers der wenigstens eine thermoelektrische Generator, das wenigstens eine Heizrohr und das wenigstens eine Kühlrohr in einer Stapelrichtung aufeinander gestapelt sind und so einen Rohrstapel bilden, in dem sich der jeweilige thermoelektrische Generator, das jeweilige Heizrohr und das jeweilige Kühlrohr parallel zueinander in einer Längsrichtung des Rohrstapels erstrecken.

EP 2 378 578 beschreibt einen Wärmetauscher für eine Abgasanlage. Die vorliegende Erfindung beschäftigt sich mit dem Problem, für einen derartigen Wärmetauscher, der zumindest einen thermoelektrischen Generator enthält, eine verbesserte oder zumindest eine andere Ausführungsform anzugeben, die sich insbesondere durch einen erhöhten energetischen Wirkungsgrad auszeichnet. Gleichzeitig ist ein einfacher und somit preiswerter Aufbau angestrebt.

Erfindungsgemäß wird dieses Problem insbesondere durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, den Wärmetauscher mit einem Gehäuse auszustatten, das in einem Innenraum den Rohrstapel aufnimmt und das einen Mantel besitzt, der den Rohrstapel in einer Umfangsrichtung umschließt. Die Umfangsrichtung bezieht sich dabei auf die Längsrichtung der Rohre bzw. des Rohrstapels. Des Weiteren beruht die Erfindung auf dem allgemeinen Gedanken, das Gehäuse bzw. den Mantel als Vorspannfeder auszugestalten, die den Rohrstapel in der Stapelrichtung verpresst, um dadurch die wärmeübertragende Kontaktierung zwischen den einzelnen Komponenten des Rohrstapels zu verbessern. Es hat sich gezeigt, dass das Beaufschlagen der im Rohrstapel aufeinandergestapelten Komponenten, also der Heizrohre, der Kühlrohre und der thermoelektrischen Generatoren zu einer verbesserten Wärmeübertragung führt, was den energetischen Wirkungsgrad des Wärmetauschers verbessert. Durch die Integration der Vorspannfunktion in das Gehäuse bzw. in den Mantel kann auf zusätzliche separate Bauteile, wie z.B.

Federelemente und Lagermatten, zum Erzeugen dieser Vorspannkraft verzichtet werden, wodurch der Wärmetauscher gleichzeitig vergleichsweise preiswert realisierbar ist.

Um diesen vorstehend skizzierten allgemeinen Grundgedanken der vorliegenden Erfindung im Wärmetauscher umzusetzen, kann gemäß einer vorteilhaften Lösung vorgesehen sein, den Mantel zumindest mit einem Vorspannabschnitt integral auszustatten, der federelastisch zwischen einem entspannten Zustand und einem gespannten Zustand verstellbar ist. Der entspannte Zustand liegt bei fehlendem Rohrstapel vor. Der gespannte Zustand liegt zumindest dann vor, wenn der Wärmetauscher fertig montiert ist. Der gespannte Zustand kann sich schon vorher einstellen, z.B. wenn der Rohrstapel in das Gehäuse eingesetzt ist und das Gehäuse bzw. der Mantel fertig montiert ist. Hierzu kann es beispielsweise erforderlich sein, das Gehäuse bzw. den Mantel zumindest in einem Axialabschnitt zumindest in der Umfangsrichtung zu schliessen. Die Integration des jeweiligen Vorspannabschnitts in den Mantel bedeutet, dass zur Erzeugung der erforderlichen Vorspannkraft kein zusätzliches separates Bauteil erforderlich ist, das am Mantel montiert werden muss, da der Vorspannabschnitt, der die gewünschte Vorspannkraft erzeugt, einen integralen Bestandteil des Mantels bildet, also durch einen entsprechenden Bereich oder Abschnitt des Mantels gebildet ist. Der jeweilige Vorspannabschnitt ist somit ein integraler Bestandteil des Gehäuses, also kein diesbezüglich separates Bauteil.

Da die mithilfe des jeweiligen Vorspannabschnitts erzeugte Vorspannkraft parallel zur Stapelrichtung wirkt, die ihrerseits senkrecht zur Längsrichtung des Plattenstapels verläuft, ergibt sich in der Umfangsrichtung eine ungleichmäßige Kraftverteilung. Die Vorspannkraft wirkt durch das Prinzip "actio = reactio" in der Stapelrichtung und in der Gegenrichtung. Quer dazu kann der jeweilige Vorspannabschnitt dagegen keine oder nur stark reduzierte Vorspannkräfte erzeugen. Der jeweilige Vorspannabschnitt erstreckt sich im Querschnitt senkrecht zur Längsmittelachse des Plattenstapels in der Umfangsrichtung über einen Winkelbereich von weniger als 180°, beispielsweise über etwa 90° oder weniger.

Bevorzugt ist der Plattenstapel aus mehreren Heizrohren und mehreren Kühlrohren aufgebaut, wobei außerdem mehrere thermoelektrische Generatoren vorgesehen sein können.

Bevorzugt besitzen die einzelnen Rohre jeweils im Wesentlichen einen Rechteckquerschnitt, so dass letztlich auch der Plattenstapel bevorzugt im Wesentlichen einen Rechteckquerschnitt besitzt. Die Stapelrichtung und die Vorspannkraft verlaufen dann durch zwei sich diametral gegenüberliegende Seiten. Im Querschnitt des Plattenstapels verlaufen diese beiden Seiten dabei dann im Wesentlichen quer zur Stapelrichtung, während die beiden anderen Seiten dann im Wesentlichen parallel zur Stapelrichtung verlaufen.

Gemäß einer vorteilhaften Ausführungsform kann der Mantel im Bereich des jeweiligen Vorspannabschnitts so konzipiert sein, dass das Gehäuse bei fehlendem Rohrstapel, also im entspannten Zustand, quer zur Längsrichtung des Gehäuses, die mit der Längsrichtung des Rohrstapels zusammenfällt, eine Innenquerschnittsfläche besitzt, die kleiner ist als eine Innenquerschnittsfläche, die das Gehäuse dann aufweist, wenn der Rohrstapel darin eingesetzt ist und der gespannte Zustand vorliegt. Mit anderen Worten, der Rohrstapel führt bei der Montage des Wärmetauschers zu einer Aufweitung des Gehäuses im Bereich des jeweiligen Vorspannabschnitts, wobei diese Aufweitung des Gehäuses reversibel und elastisch erfolgt. Hierdurch kann der jeweilige Vorspannabschnitt besonders einfach als Feder wirken, mit deren Hilfe die gewünschten Vorspannkräfte realisierbar sind.

Das Gehäuse kann bspw. mithilfe eines in der Umfangsrichtung geschlossen umlaufenden Mantels gebildet sein, dessen Umfangsenden auf geeignete Weise miteinander fest verbunden sind, bspw. über eine Schweißnaht oder eine Bördelverbindung. Der Rohrstapel ist bei einer derartigen Ausführungsform dann axial in den Mantel einzuführen, so dass sich beim Einführen des Rohrstapels in den Mantel die vorstehend genannte Aufweitung des Innenquerschnitts ergibt. Alternativ dazu kann das Gehäuse auch aus zwei Halbschalen gebildet sein, die im Bereich einer Trennebene an den einander zugewandten Enden aneinander befestigt werden, bpsw. mittels Schweißverbindungen oder Bördelverbindungen. Bei einer derartigen Ausführungsform wird der Rohrstapel zunächst in die eine Gehäusehälfte eingelegt. Im Anschluss daran wird die andere Gehäusehälfte aufgesetzt, wobei zum Verschließen des Gehäuses in der Umfangsrichtung, also zum Festlegen der beiden Gehäusehälften aneinander, das Gehäuse im jeweiligen Vorspannabschnitt elastisch verformt werden muss, um das Gehäuse schließen zu können.

Bei einer vorteilhaften Ausführungsform kann der Mantel zumindest zwei solche integrierte Vorspannabschnitte aufweisen, die sich bzgl. der Stapelrichtung gegenüberliegen. Durch diese Maßnahme kann der einzelne Vorspannabschnitt kleiner dimensioniert werden, was die Realisierung der Vorspannabschnitte im Mantel vereinfacht.

Bei einer anderen vorteilhaften Ausführungsform kann zumindest ein solcher Vorspannabschnitt im entspannten Zustand in der Stapelrichtung zum Innenraum des Gehäuses hin konvex gewölbt sein. Im entspannten Zustand besitzt diese konvexe Wölbung einen Biegeradius, der beim Einbringen des Rohrstapels bzw. beim Überführen des Mantels in den gespannten Zustand signifikant vergrößert wird, insbesondere kann der Vorspannabschnitt im gespannten Zustand eben werden. Eine derartige Bauform ermöglicht bei preiswerter Realisierbarkeit vergleichsweise hohe Vorspannkräfte.

Bei einer anderen Ausführungsform kann zumindest ein solcher Vorspannabschnitt einen ebenen, senkrecht zur Stapelrichtung verlaufenden Kontaktbereich und zwei Federbereiche aufweisen, die beiderseits des Kontaktbereichs angeordnet sind, und die den Kontaktbereich an der jeweiligen Seite mit entlang der Stapelrichtung, vorzugsweise parallel dazu, verlaufenden Wandabschnitten des Mantels verbinden. Mithilfe des ebenen Kontaktbereichs kann die Flächenpressung an den betroffenen Außenseiten des Rohrstapels homogenisiert werden. Sofern das Gehäuse aus zwei Halbschalen besteht, verläuft die Trennebene zweckmäßig durch die beiden sich entlang der Stapelrichtung erstreckenden Wandabschnitte. Alternativ ist es ebenso möglich, die Trennebene anders anzuordnen, z.B. durch den Kontaktbereich hindurch zu verlegen.

Bei einer anderen vorteilhaften Ausführungsform kann der Mantel zwei sich entlang der Stapelrichtung, vorzugsweise parallel dazu, erstreckende, insbesondere geradlinige, Wandabschnitte aufweisen, die sich quer zur Stapelrichtung und quer zur Längsrichtung des Rohrstapels gegenüberliegen. Diese Wandabschnitte nehmen die Vorspannkräfte auf. Dabei werden die Wandabschnitte nur auf Zug beansprucht, wodurch sie mit einer vergleichsweise geringen Wandstärke realisierbar sind.

Gemäß einer anderen vorteilhaften Ausführungsform kann das Gehäuse in einer sich senkrecht zur Stapelrichtung erstreckenden Teilungsebene geteilt sein und ein Oberteil sowie ein Unterteil aufweisen, wobei zumindest eines dieser Teile zumindest einen solchen Vorspannabschnitt aufweist. Wie bereits erläutert, kann durch die Teilung des Gehäuses die Montage vereinfacht werden.

Gemäß einer anderen vorteilhaften Ausführungsform kann sich der jeweilige Vorspannabschnitt in der Längsrichtung des Gehäuses im Wesentlichen über die gesamte Länge des Rohrstapels erstrecken. Auf diese Weise kann über die gesamte Länge des Rohrstapels eine möglichst homogene Vorspannung realisiert werden. Alternativ ist grundsätzlich auch eine Ausführungsform denkbar, bei welcher das Gehäuse in der Längsrichtung mehrere singuläre Vorspannabschnitte aufweist, die in der Längsrichtung nebeneinander angeordnet sind. Bspw. können derartige einzelne Vorspannabschnitte auf den Aufbau der thermoelektrischen Generatoren abgestimmt sein, die in der Regel aus mehreren, in der Längsrichtung hintereinander bzw. nebeneinander angeordneten thermoelektrischen Elementen zusammengebaut sind. Insbesondere kann somit eine Ausführungsform realisiert werden, bei der je thermoelektrischem Element innerhalb des jeweiligen thermoelektrischen Generators ein separater Vorspannabschnitt vorgesehen ist.

Gemäß einer anderen vorteilhaften Weiterbildung kann der Mantel im Bereich des jeweiligen Vorspannabschnitts eine größere Wandstärke aufweisen als im Bereich des jeweiligen entlang der Stapelrichtung verlaufenden Wandabschnitts. Eine derartige Konfiguration lässt sich bspw. mithilfe sogenannter "tailored blanks" realisieren, also mithilfe von Blechen, die aus mehreren Blechen unterschiedlicher Blechdicke zusammengebaut sind. Auf diese Weise lassen sich die Gehäuseteile hinsichtlich ihrer Beanspruchungen optimieren.

Zusätzlich oder alternativ kann gemäß einer anderen vorteilhaften Weiterbildung der Mantel im Bereich des jeweiligen Vorspannabschnitts aus einem anderen Material hergestellt sein als im Bereich des jeweiligen entlang der Stapelrichtung verlaufenden Wandabschnitts. Auch eine derartige Konfiguration lässt sich bspw. mithilfe von "tailored blanks" realisieren, also mithilfe von Blechen, die in diesem Fall aus mehreren Blechen unterschiedlicher Materialien zusammengebaut sind. Auf diese Weise lassen sich die Gehäuseteile hinsichtlich ihrer Beanspruchungen optimieren.

Auch ist eine Kombination der vorstehenden Ausgestaltungen denkbar, derart, dass der Mantel im Bereich des jeweiligen Vorspannabschnitts eine größere Wandstärke aufweist und aus einem anderen Material hergestellt ist als im Bereich des jeweiligen entlang der Stapelrichtung verlaufenden Wandabschnitts. Auch eine derartige Konfiguration lässt sich bspw. mithilfe von "tailored blanks" realisieren, also mithilfe von Blechen, die aus mehreren Blechen unterschiedlicher Blechdicke und unterschiedlicher Materialien zusammengebaut sind.

Bei einer anderen vorteilhaften Ausführungsform kann das jeweilige Heizrohr bzw. das jeweilige Kühlrohr in seinem Inneren zumindest im Bereich des jeweiligen Vorspannabschnitts eine Stützstruktur aufweisen, die das jeweilige Rohr in der Stapelrichtung aussteift. Mithilfe der Vorspannabschnitte können vergleichsweise große Vorspannkräfte in den Rohrstapel eingeleitet werden. Um nun ein Ausweichen der Heizrohre bzw. Kühlrohre durch Beulenbildung zu vermeiden, kann das jeweilige Rohr mithilfe einer derartigen Stützstruktur ausgesteift werden, welche die Vorspannkräfte zwischen der in der Stapelrichtung einander gegenüberliegenden Wände des jeweiligen Rohrs überträgt.

Zusätzlich oder alternativ kann vorgesehen sein, dass in der Stapelrichtung zwischen dem Mantel und dem obersten Rohr und/oder zwischen dem Mantel und dem untersten Rohr eine Versteifungsplatte angeordnet ist. Im gespannten Zustand wirkt der jeweilige Vorspannabschnitt dann mit einer solchen Versteifungsplatte zusammen, welche die darin eingeleitete Vorspannkraft homogen auf das daran angrenzende Rohr bzw. den Rohrstapel überträgt.

Eine erfindungsgemäße Brennkraftmaschine, die insbesondere in einem Kraftfahrzeug zur Anwendung kommt, umfasst einen Motorblock, der mehrere Brennräume aufweist, eine Abgasanlage zum Abführen von Verbrennungsabgas von den Brennräumen, einen Kühlkreis zum Kühlen des Motorblocks und zumindest einen Wärmetauscher der vorstehend beschriebenen Art. Dabei ist das wenigstens eine Heizrohr des Wärmetauschers fluidisch mit der Abgasanlage gekoppelt, während das wenigstens eine Kühlrohr des Wärmetauschers fluidisch mit dem Kühlkreis gekoppelt ist.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: eine stark vereinfachte, schaltplanartige Prinzipdarstellung einer Brennkraftmaschine,
- Fig. 2: ein stark vereinfachter, schematischer Querschnitt eines Wärmetauschers,
- Fig. 3: eine vereinfachte Seitenansicht des Wärmetauschers,
- Fig. 4: einen Querschnitt durch einen Mantel eines Gehäuses des Wärmetauschers in einem entspannten Zustand
- Fig. 5: einen Querschnitt des Mantels aus Fig. 4, jedoch bei einem gespannten Zustand,
- Fig. 6: einen Querschnitt des Mantels im entspannten Zustand wie in Fig. 4, jedoch bei einer anderen Ausführungsform,
- Fig. 7: ein Querschnitt des Mantels aus Fig. 6, jedoch im gespannten Zustand.

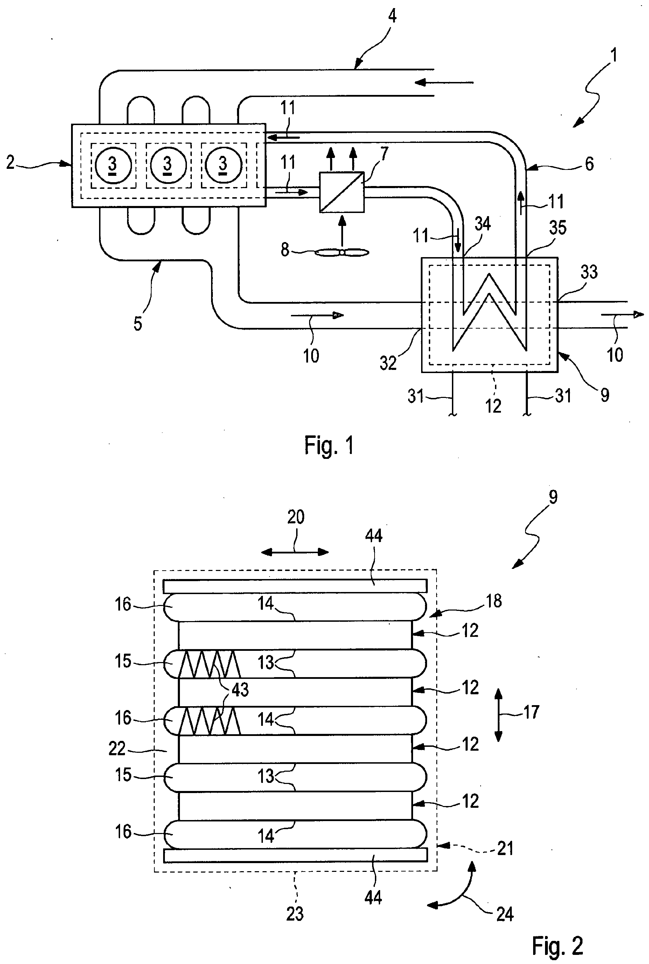

Entsprechend Fig. 1 umfasst eine Brennkraftmaschine 1, die insbesondere in einem Kraftfahrzeug angeordnet sein kann, einen Motorblock 2, der mehrere Brennräume 3 enthält, in denen bei Verbrennungsreaktionen Abgas entsteht. Eine Frischluftanlage 4 versorgt die Brennräume 3 mit Frischluft. Eine Abgasanlage 5 führt das Abgas 10 von den Brennräumen 3 ab. Die Brennkraftmaschine 1 ist ferner mit einem Kühlkreis 6 ausgestattet, in dem ein Kühlmittel 11 zirkuliert und mit dessen Hilfe der Motorblock 2 gekühlt werden kann. In üblicher Weise ist dabei in den Kühlkreis 6 ein Motorkühler 7 eingebunden, der bspw. aktiv mit Hilfe eines Gebläses 8 von Umgebungsluft durchströmt werden kann. Die hier vorgestellte Brennkraftmaschine 1 ist außerdem mit einem Wärmetauscher 9 ausgestattet, der einerseits fluidisch in die Abgasanlage 5 und andererseits fluidisch in den Kühlkreis 6 eingebunden ist, derart, dass eine Wärmeübertragung zwischen dem als Heizmittel 10 dienenden Abgas der Abgasanlage 5 und dem Kühlmittel 11 des Kühlkreises 6 realisierbar ist.

Gemäß Fig. 1 besitzt der Wärmetauscher 9 einen Heizmitteleinlass 32, einen Heizmittelauslass 33, einen Kühlmitteleinlass 34 und einen Kühlmittelauslass 35. Die Strömungsrichtung des Heizmittels 10 führt vom Heizmitteleinlass 32 zum Heizmittelauslass 33. Die Strömungsrichtung des Kühlmittels 11 führt vom Kühlmitteleinlass 34 zum Kühlmittelauslass 35.

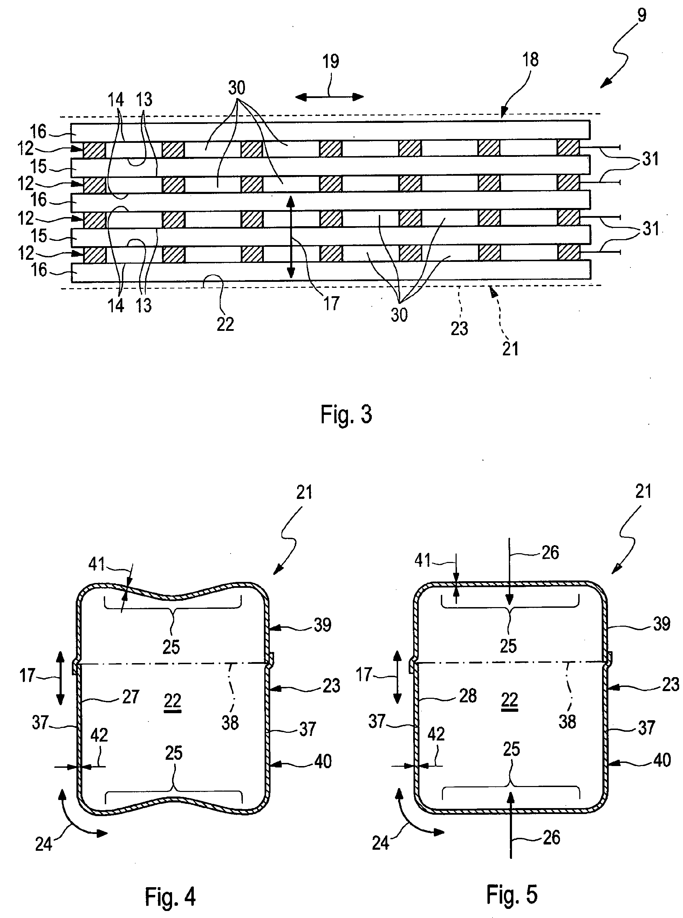

Ein derartiger Wärmetauscher 9 umfasst gemäß den Fig. 2 und 3 zumindest einen thermoelektrischen Generator 12. In der in den Fig. 2 und 3 gezeigten Ausführungsform besitzt der Wärmetauscher 9 rein exemplarisch vier derartige thermoelektrische Generatoren 12. Der jeweilige thermoelektrische Generator 12 besitzt dabei jeweils eine Heißseite 13 und eine Kaltseite 14. Desweiteren umfasst der Wärmetauscher 9 zumindest ein Heizrohr 15. Im gezeigten Beispiel sind zwei derartige Heizrohre 15 vorgesehen. Das jeweilige Heizrohr 15 dient zum Führen des Heizmittels 10 und ist jeweils an zumindest einer Heißseite 13 eines solchen thermoelektrischen Generators 12 angeordnet. Im gezeigten Beispiel ist jedes Heizrohr 15 an zwei einander zugewandten Heißseiten 13 von zwei benachbarten thermoelektrischen Generatoren 12 angeordnet. Schließlich umfasst der Wärmetauscher 9 noch wenigstens ein Kühlrohr 16. Im gezeigten Beispiel sind drei derartige Kühlrohre 16 vorgesehen, nämlich zwei äußere Kühlrohre 16 und ein mittleres Kühlrohr 16. Das jeweilige Kühlrohr 16 dient zum Führen des Kühlmittels 11 und ist dabei an wenigstens einer Kaltseite 14 wenigstens eines solchen thermoelektrischen Generators 12 angeordnet. Im Beispiel sind die beiden äußeren Kühlrohre 16 jeweils einer Kaltseite 14 eines thermoelektrischen Generators 12 angeordnet. Im Unterschied dazu ist das mittlere Kühlrohr 16 an zwei einander gegenüberliegenden Kaltseiten 14 von zwei benachbarten thermoelektrischen Generatoren 12 angeordnet.

Entsprechend Fig. 3 ist der jeweilige thermoelektrische Generator 12 in üblicher Weise aus mehreren separaten thermoelektrischen Elementen 30 zusammengebaut, die in der Längsrichtung 19 hintereinander angeordnet sind und die auf geeignete Weise elektrisch miteinander verbunden sind. Entsprechende elektrische Anschlüsse 31 sind aus dem Wärmetauscher 9 herausgeführt, wodurch der aus der Wärme des Abgases 10 gewonnene elektrische Strom abgeführt werden kann.

Die thermoelektrischen Generatoren 12, die Heizrohre 15 und die Kühlrohre 16 sind in einer Stapelrichtung 17 aufeinander gestapelt und bilden so einen Rohrstapel 18. Innerhalb des Rohrstapels 18 erstrecken sich die thermoelektrischen Generatoren 12, die Heizrohre 15 und die Kühlrohre 16 parallel zueinander und definieren dadurch eine Längsrichtung 19 des Rohrstapels 18. In Fig. 2 ist außerdem eine Querrichtung 20 des Rohrstapels 18 angedeutet, die sich quer zur Stapelrichtung 17 und quer zur Längsrichtung 19 erstreckt.

Der Wärmetauscher 9 weist außerdem ein Gehäuse 21 auf, das in den Fig. 2 und 3 mit unterbrochene Linie angedeutet ist, und das einen Innenraum 22 umhüllt, in dem der Rohrstapel 18 untergebracht ist. Das Gehäuse 21 besitzt einen Mantel 23, der den Rohrstapel 18 in einer in Fig. 2 durch einen Doppelpfeil angedeuteten Umfangsrichtung 24 umschließt. Die Umfangsrichtung 24 bezieht sich dabei auf die Längsrichtung 19 des Rohrstapels 18 bzw. der Rohre 15, 16. Die Gestaltung des Gehäuses 21 bzw. des Mantels 23 wird im Folgenden anhand der Figuren 4 bis 7 näher erläutert. Das Gehäuse 21 kann an seinen Längsenden offen sein oder mit Böden verschlossen sein.

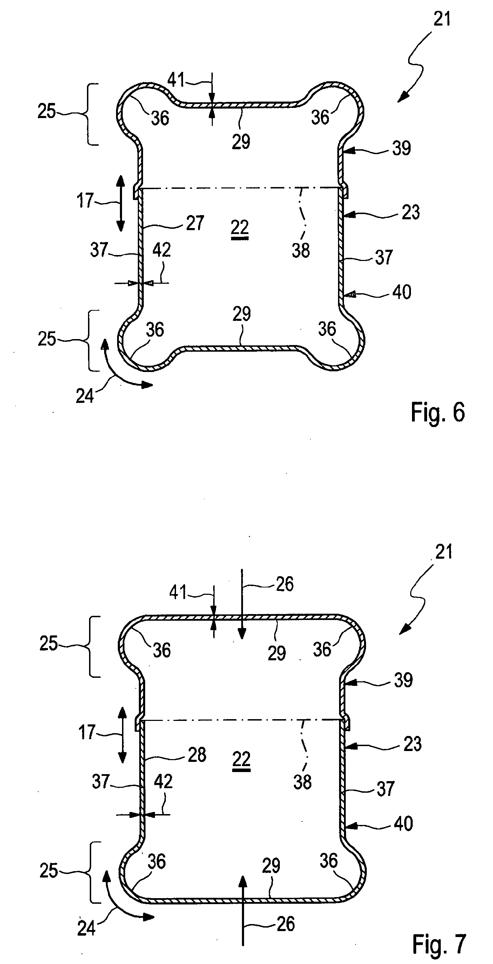

Gemäß den Fig. 4 bis 7 besitzt der Mantel 23 zumindest einen Vorspannabschnitt 25, der in den Figuren 4 bis 7 jeweils durch eine geschweifte Klammer angedeutet ist. In den gezeigten Querschnitten sind dabei jeweils zwei derartige Vorspannabschnitte 25 vorgesehen, die sich bzgl. der Stapelrichtung 17 gegenüberliegen. Die Vorspannabschnitte 25 sind im Mantel 23 integral ausgeformt, bilden somit also jeweils einen integralen Bestandteil des Mantels 23. Die Vorspannabschnitte 25 sind jeweils sind jeweils zwischen einem in den Fig. 4 und 6 gezeigten entspannten Zustand und einem in den Fig. 5 und 7 gezeigten gespannten Zustand verstellbar. Der entspannte Zustand gemäß den Fig. 4 und 6 liegt dann vor, wenn der Rohrstapel 18 nicht im Gehäuse 21 untergebracht ist. Dagegen liegt der gespannte Zustand gemäß den Fig. 5 und 7 dann vor, wenn der Rohrstapel 18 im Gehäuse 21 angeordnet ist und wenn zumindest der Mantel 23 des Gehäuses 21 in der Umfangsrichtung zugeschlossen ist. In diesem gespannten Zustand erzeugen die Vorspannabschnitte 25 gemäß den Fig. 5 und 7 jeweils eine durch einen Pfeil angedeutete Vorspannkraft 26. Diese Vorspannkräfte 26 verlaufen dabei parallel zur Stapelrichtung 17 sind in den Innenraum 22 hinein orientiert. Somit können die Vorspannkräfte 26 den im Innenraum 22 untergebrachten Rohrstapel 18 in der Stapelrichtung 17 verpressen. In den Fig. 5 und 7 ist zur Wahrung der Übersichtlichkeit der Rohrstapel 18 nicht dargestellt. Im entspannten Zustand besitzt das Gehäuse 21 bzw. der Mantel 23 in dem in den Fig. 4 und 6 gezeigten, quer zur Längsrichtung 19 verlaufenden Querschnitten jeweils eine Innenquerschnittsfläche 27, die im Folgenden als entspannte Innenquerschnittsfläche 27 bezeichnet wird. Dagegen besitzt das jeweilige Gehäuse 21 bzw. der jeweilige Mantel 23 im gespannten Zustand in besagtem Querschnitt gemäß den Fig. 5 und 7 eine Innenquerschnittsfläche 28, die im Folgenden als gespannte Innenquerschnittsfläche 28 bezeichnet wird. Durch Vergleich der Fig. 4 und 5 bzw. durch Vergleich der Fig. 6 und 7 ist erkennbar, dass die entspannte Innenquerschnittsfläche 27 des Gehäuses 21 bzw. des Mantels 23 kleiner ist als die gespannte Innenquerschnittsfläche 28. Das bedeutet, dass der in das Gehäuse 21 eingebrachte Rohrstapel 18 zu einer Aufweitung des Gehäuses 21 bzw. des Mantel 23 führt, zumindest im Bereich des jeweiligen Vorspannabschnitts 25. Diese Querschnittsaufweitung ist dabei reversibel und elastisch, so dass die Vorspannabschnitte 25 als Federn wirken.

Bei der in den Fig. 4 und 5 gezeigten Ausführungsform sind die Vorspannabschnitte 25 so gestaltet, dass sie im entspannten Zustand gemäß Fig. 4 in der Stapelrichtung 17 zum Innenraum 22 des Gehäuses 21 hin konvex gewölbt sind. Die Abmessungen des Gehäuses 21 bzw. des Mantels 23 sind dabei gezielt so gewählt, dass sich im gespannten Zustand gemäß Fig. 5 eine ebene Ausrichtung der Vorspannabschnitte 25 einstellt, wodurch eine vordefinierte Vorspannung 26 in den Rohrstapel 18 einleitbar ist.

Bei der in den Fig. 6 und 7 gezeigten Ausführungsform sind die Vorspannabschnitte 25 so gestaltet, dass der jeweilige Vorspannabschnitt 25 einen Kontaktbereich 29 und zwei Federbereiche 36 aufweist. Der jeweilige Kontaktbereich 29 ist dabei eben konfiguriert und erstreckt sich dabei vorzugsweise senkrecht zur Stapelrichtung 17. Die Federbereiche 26 sind beiderseits des Kontaktbereichs 29 angeordnet und sind dabei so geformt, dass sie den jeweiligen Kontaktbereich 29 an der jeweilige Seite mit Wandabschnitten 37 des Mantels 23 verbinden, die parallel zur Stapelrichtung 17 verlaufen. Ferner sind diese Federbereiche 36 als Federn konzipiert, die den jeweiligen Kontaktbereich 29 zum Erzeugen der Vorspannkräfte 26 parallel zur Stapelrichtung 17 zum Innenraum 22 hin vorspannen.

Bei den Ausführungsformen der Fig. 4 bis 7 ist das Gehäuse 21 jeweils in einer Teilungsebene 38, die senkrecht zur Stapelrichtung 17 verläuft, geteilt, derart, dass das jeweilige Gehäuse 21 ein Oberteil 39 und ein Unterteil 40 besitzt. Die Teilungsebene 38 verläuft dabei durch die zuvor genannten Wandabschnitte 37, die sich quer zur Stapelrichtung 17 gegenüberliegen und dabei quer zur Längsrichtung 19 des Rohrstapels 18 und parallel zur Stapelrichtung 17 verlaufen. Somit besitzt bei den hier gezeigten Konfigurationen das Oberteil 39 zumindest einen solchen Vorspannabschnitt 25. Ebenso besitzt das jeweilige Unterteil 40 jeweils mindestens einen solchen Vorspannabschnitt 25.

Grundsätzlich ist auch denkbar, die Teilungsebene 38 um 90° zu drehen, derart, dass die jeweilige Teilungsebene 38 durch die sich in der Stapelrichtung 17 gegenüber liegenden Vorspannabschnitte 25 verläuft.

Bei den hier gezeigten Ausführungsformen erstreckt sich der jeweilige Vorspannabschnitt 25 in der Längsrichtung 19 des Gehäuses 21 im Wesentlichen über die gesamte Länge des Rohrstapels 18. Demnach besitzen die hier gezeigten Gehäuse 21 jeweils zwei Vorspannabschnitte 25, nämlich jeweils einen im Oberteil 39 und einen im Unterteil 40. Alternativ dazu können auch mehrere singuläre Vorspannabschnitte 25 in der Längsrichtung 19 aufeinanderfolgen. Bspw. können gemäß der Aufteilung der Fig. 3 fünf Vorspannabschnitte 25 in der Längsrichtung 19 aufeinanderfolgen, die jeweils im Bereich der in der Stapelrichtung 17 übereinander liegenden thermoelektrischen Elemente 30 angeordnet sind, aus denen sich die einzelnen thermoelektrischen Generatoren 12 zusammensetzen.

Gemäß einer vorteilhaften Ausführungsform kann der Mantel 23 im Bereich des jeweiligen Vorspannabschnitts 25 eine Wandstärke 41 aufweisen, die größer ist als eine Wandstärke 42, die der Mantel 23 in einem der Wandabschnitte 37 besitzt. Zusätzlich oder alternativ kann vorgesehen sein, dass der Mantel 23 im Bereich des jeweiligen Vorspannabschnitts 25 aus einem anderen Material hergestellt ist als im Bereich der Wandabschnitte 37. Derartige Konfigurationen können bspw. mittels tailored blanks realisiert werden, welche als Rohlinge zum Herstellen der Gehäuse 39, 40 durch Umformung verwendet werden können.

Gemäß Fig. 2 können in den Heizrohren 15 bzw. in den Kühlrohren 16 Stützstrukturen 43 angeordnet sein, die das jeweilige Rohr 15, 16 in der Stapelrichtung 17 aussteifen. In Fig. 2 ist rein exemplarisch nur in einem der Heizrohre 15 und nur in einem der Kühlrohre 16 ein Abschnitt einer derartigen Stützstruktur 43 angedeutet.

Zusätzlich oder alternativ zu einer derartigen Stützstruktur 43 kann gemäß Fig. 2 vorgesehen sein, dass in der Stapelrichtung 17 zwischen dem Mantel 23 und dem obersten Rohr, hier ein Kühlrohr 16, und/oder zwischen dem Mantel 23 und dem untersten Rohr, hier ein Kühlrohr 16, eine Versteifungsplatte 44 angeordnet ist. Im gespannten Zustand wirkt der jeweilige Vorspannabschnitt 25 dann mit jeweils einer solchen Versteifungsplatte 44 zusammen, welche die darin eingeleitete Vorspannkraft 26 homogen auf das jeweilige daran angrenzende Rohr, hier das jeweilige Kühlrohr 16, bzw. auf den Rohrstapel 18 überträgt.

## Patentansprüche

1. Wärmetauscher, insbesondere für eine Abgasanlage (5) einer Brennkraftmaschine (1), vorzugsweise in einem Kraftfahrzeug,
- mit mindestens einem thermoelektrischen Generator (12), der eine Heißseite (13) und eine Kaltseite (14) aufweist,
- mit mindestens einem Heizrohr (15) zum Führen eines Heizmittels (10), das an der Warmseite (13) wenigstens eines solchen thermoelektrischen Generators (12) angeordnet ist,
- mit mindestens einem Kühlrohr (16) zum Führen eines Kühlmittels (11), das an der Kaltseite (14) wenigstens eines solchen thermoelektrischen Generators (12) angeordnet ist,
- wobei der wenigstens eine thermoelektrische Generator (12) das wenigstens eine Heizrohr (15) und das wenigstens eine Kühlrohr (16) in einer Stapelrichtung (17) aufeinander gestapelt sind und einen Rohrstapel (18) bilden,
- mit einem Gehäuse (21), dessen Innenraum (22) den Rohrstapel (18) aufnimmt und dessen Mantel (23) den Rohrstapel (18) in einer Umfangsrichtung (24) umschließt,
- wobei der Mantel (23) zumindest einen Vorspannabschnitt (25) integral aufweist, der federelastisch zwischen einem entspannten Zustand, der zumindest bei fehlendem Rohrstapel (18) vorliegt, und einem gespannten Zustand verstellbar ist, der zumindest beim fertig montierten Wärmetauscher (9) vorliegt,
- wobei der jeweilige Vorspannabschnitt (25) im gespannten Zustand eine den Rohrstapel (18) in der Stapelrichtung (17) verpressende Vorspannkraft (26) erzeugt.

2. Wärmetauscher nach Anspruch 1,
**dadurch gekennzeichnet,**
**dass** der Mantel (23) im entspannten Zustand quer zur Längsrichtung (19) des Gehäuses (21) eine Innenquerschnittsfläche (27) besitzt, die kleiner ist als eine Innenquerschnittsfläche (28), die der Mantel (23) im gespannten Zustand aufweist.

3. Wärmetauscher nach Anspruch 1 oder 2,
**dadurch gekennzeichnet,**
**dass** der Mantel (23) zumindest zwei solche integrierte Vorspannabschnitte (25) aufweist, die sich bzgl. der Stapelrichtung (17) gegenüberliegen.

4. Wärmetauscher nach einem der Ansprüche 1 bis 3,
**dadurch gekennzeichnet,**
**dass** zumindest ein solcher Verspannabschnitt (25) im entspannten Zustand in der Stapelrichtung (17) zum Innenraum (22) des Gehäuses (21) hin konvex gewölbt ist.

5. Wärmetauscher nach einem der Ansprüche 1 bis 3,
**dadurch gekennzeichnet,**
**dass** zumindest ein solcher Vorspannabschnitt (25) einen ebenen, senkrecht zur Stapelrichtung (17) verlaufenden Kontaktbereich (29) und zwei Federbereiche (36) aufweist, die beiderseits des Kontaktbereichs (29) angeordnet sind und die den Kontaktbereich (29) an der jeweiligen Seite mit parallel zur Stapelrichtung (17) verlaufenden Wandabschnitte (37) des Mantels (23) verbinden.

6. Wärmetauscher nach einem der Ansprüche 1 bis 5,
**dadurch gekennzeichnet,**
**dass** der Mantel (23) zwei sich entlang der Stapelrichtung (17) erstreckende Wandabschnitte (37) aufweist, die sich quer zur Stapelrichtung (17) gegenüberliegen.

7. Wärmetauscher nach einem der Ansprüche 1 bis 6,
**dadurch gekennzeichnet,**
**dass** das Gehäuse (21) in einer sich senkrecht zur Stapelrichtung (17) erstreckenden Teilungsebene (38) geteilt ist und ein Oberteil (39) sowie ein Unterteil (40) aufweist, wobei zumindest eines dieser Teile (39, 40) wenigstens einen solchen Vorspannabschnitt (25) aufweist.

8. Wärmetauscher nach einem der Ansprüche 1 bis 7,
**dadurch gekennzeichnet,**
**dass** sich der jeweilige Vorspannabschnitt (25) in der Längsrichtung (19) des Gehäuses (21) im Wesentlichen über die gesamte Länge des Rohrstapels (18) erstreckt.

9. Wärmetauscher zumindest nach Anspruch 6,
**dadurch gekennzeichnet,**
**dass** der Mantel (23) im Bereich des jeweiligen Vorspannabschnitts (25) eine Wandstärke (41) aufweist, die größer ist als eine Wandstärke (42), die der Mantel (23) im Bereich des jeweiligen Wandabschnitts (37) aufweist.

10. Wärmetauscher zumindest nach Anspruch 6,
**dadurch gekennzeichnet,**
**dass** der Mantel (23) im Bereich des jeweiligen Vorspannabschnitts (25) aus einem anderem Material hergestellt ist als im Bereich des jeweiligen Wandabschnitts (37).

11. Wärmetauscher nach einem der Ansprüche 1 bis 10,
**dadurch gekennzeichnet,**
**dass** das jeweilige Heizrohr (15) und/oder das jeweilige Kühlrohr (16) in seinem Inneren eine Stützstruktur (43) aufweist, die das jeweilige Rohr (15, 16) in der Stapelrichtung (17) aussteift.

12. Wärmetauscher nach einem der Ansprüche 1 bis 11,
**dadurch gekennzeichnet,**
**dass** in der Stapelrichtung (17) zwischen dem Mantel (23) und dem Rohrstapel (18) zumindest eine Versteifungsplatte (44) angeordnet ist.

13. Brennkraftmaschine, insbesondere eines Kraftfahrzeugs,
- mit einem Motorblock (2), der mehrere Brennräume (3) aufweist,
- mit einer Abgasanlage (5) zum Abführen von Verbrennungsabgas (10) von den Brennräumen (3),
- mit einem Kühlkreis (6) zum Kühlen des Motorblocks (2),
- mit einem Wärmetauscher (9) nach einem der Ansprüche 1 bis 12, dessen Heizrohre (15) fluidisch mit der Abgasanlage (5) gekoppelt sind und dessen Kühlrohre (16) fluidisch mit dem Kühlkreis (6) gekoppelt sind.

## Claims

1. A heat exchanger, in particular for an exhaust system (5) of an internal combustion engine (1), preferentially in a motor vehicle,
- with at least one thermoelectric generator (12), which has a hot side (13) and a cold side (14),
- with at least one heating tube (15) for conducting a heating medium (10), which is arranged on the warm side (13) of at least one such thermoelectric generator (12),
- with at least one cooling tube (16) for conducting a cooling medium (11), which is arranged on the cold side (14) of at least one such thermoelectric generator (12),
- wherein the at least one thermoelectric generator (12), the at least one heating tube (15) and the at least one cooling tube (16) are stacked on top of one another in a stacking direction (17) and form a tube stack (18),
- with a housing (21), the interior (22) of which accommodates the tube stack (18) and the jacket (23) encloses the tube stack (18) in a circumferential direction (24),
- wherein the jacket (23) integrally comprises at least one pre-tensioning section (25), which is resiliently adjustable between a relaxed state, which is at least present with an absent tube stack (18) and a tensioned state, which is at least present with the finally assembled heat exchanger (9),
- wherein the respective pre-tensioning section (25) in the tensioned state generates a pre-tensioning force (26) pressing the tube stack (18) in the stacking direction (17).

2. The heat exchanger according to Claim 1,
**characterized in that**
the jacket (23) in the relaxed state has an inner cross-sectional area (27) transversely to the longitudinal direction (19) of the housing (21) that is smaller than an inner cross-sectional area (28) which the jacket (23) has in the tensioned state.

3. The heat exchanger according to Claim 1 or 2,
**characterized in that**
the jacket (23) comprises at least two such integrated pre-tensioning sections (25), which are located opposite one another with respect to the stacking direction (17).

4. The heat exchanger according to any one of the Claims 1 to 3,
**characterized in that**
at least one such pre-tensioning section (25) is convexly curved in the relaxed state in the stacking direction (17) towards the interior (22) of the housing (21).

5. The heat exchanger according to any one of the Claims 1 to 3,
**characterized in that**
at least one such pre-tensioning section (25) comprises a flat contact region (29) running perpendicularly to the stacking direction (17) and two spring regions (36), which are arranged on both sides of the contact region (29) and which connects the contact region (29) on the respective side to wall sections (37) of the jacket (23) running parallel to the stacking direction (17).

6. The heat exchanger according to any one of the Claims 1 to 5,
**characterized in that**
the jacket (23) comprises two wall sections (37) extending along the stacking direction (17), which are located opposite one another transversely to the stacking direction (17).

7. The heat exchanger according to any one of the Claims 1 to 6,
**characterized in that**
the housing (21) is divided in a division plane (38) extending perpendicularly to the stacking direction (17) and comprises an upper part (39) and a lower part (40), wherein at least one of these parts (39, 40) comprises at least one such pre-tensioning section (25).

8. The heat exchanger according to any one of the Claims 1 to 7,
**characterized in that**
the respective pre-tensioning section (25) in the longitudinal direction (19) of the housing (21) substantially extends over the entire length of the tube stack (18).

9. The heat exchanger at least according to Claim 6,
**characterized in that**
the jacket (23) in the region of the respective pre-tensioning section (25) has a wall thickness (41) which is greater than a wall thickness (42) which the jacket (23) has in the region of the respective wall section (37).

10. The heat exchanger at least according to Claim 6,
**characterized in that**
the jacket (23) in the region of the respective pre-tensioning section (25) is produced from a material other than in the region of the respective wall section (37).

11. The heat exchanger according to any one of the Claims 1 to 10,
**characterized in that**
the respective heating tube (15) and/or the respective cooling tube (16) in its interior comprises a support structure (43), which stiffens the respective tube (15, 16) in the stacking direction (17).

12. The heat exchanger according to any one of the Claims 1 to 11,
**characterized in that**
in the stacking direction (17) between the jacket (23) and the tube stack (18) at least one stiffening plate (44) is arranged.

13. An internal combustion engine, in particular of a motor vehicle,
- with an engine block (2), which comprises multiple combustion chambers (3),
- with an exhaust system (5) for discharging combustion exhaust gas (10) from the combustion chambers (3),
- with a cooling circuit (6) for cooling the engine block (2),
- with a heat exchanger (9) according to any one of the Claims 1 to 12, the heating tubes (15) of which are fluidically coupled to the exhaust system (5) and the cooling tubes (16) of which are fluidically coupled to the cooling circuit (6).

## Revendications

1. Echangeur de chaleur, en particulier pour un système de gaz d'échappement (5) d'un moteur à combustion interne (1), de préférence dans un véhicule automobile,
- comprenant au moins un générateur (12) thermoélectrique, qui présente un côté chaud (13) et un côté froid (14),
- comprenant au moins un tube de chauffage (15) servant à acheminer un agent de chauffage (10), lequel est disposé au niveau du côté chaud (13) au moins d'un générateur (12) thermoélectrique de ce type,
- comprenant au moins un tube de refroidissement (16) servant à acheminer un agent de refroidissement (11), qui est disposé au niveau du côté froid (14) au moins d'un générateur (12) thermoélectrique de ce type,
- le générateur (12) thermoélectrique au moins au nombre de un, le tube de chauffage (15) au moins au nombre de un et le tube de refroidissement (16) au moins au nombre de un étant empilés les uns sur les autres dans une direction d'empilement (17) et formant une pile de tubes (18),
- comprenant un boîtier (21), dont l'espace intérieur (22) accueille la pile de tubes (18) et dont la gaine (23) entoure la pile de tubes (18) dans une direction périphérique (24),
- la gaine (23) présentant de manière intégrale au moins une section de précontrainte (25), qui peut être ajustée de manière élastique entre un état détendu, qui est de mise lors qu'une pile de tubes (18) est inexistante, et un état tendu, qui est de mise au moins lorsque le montage de l'échangeur de chaleur (9) est finalisé,
- la section de précontrainte (25) respective générant, dans l'état tendu, une force de précontrainte (26) comprimant la pile de tubes (18) dans la direction d'empilement (17).

2. Echangeur de chaleur selon la revendication 1,
**caractérisé en ce**
**que** la gaine (23) possède, dans l'état détendu, de manière transversale par rapport à la direction longitudinale (19) du boîtier (21), une surface de section transversale intérieure (27), qui est plus petite qu'une surface de section transversale intérieure (28), que la gaine (23) présente dans l'état tendu.

3. Echangeur de chaleur selon la revendication 1 ou 2,
**caractérisé en ce**
**que** la gaine (23) présente au moins deux sections de précontrainte (25) intégrées de ce type, qui se font face par rapport à la direction d'empilement (17).

4. Echangeur de chaleur selon l'une quelconque des revendications 1 à 3,
**caractérisé en ce**
**qu'**au moins une section de précontrainte (25) de ce type est bombée de manière convexe en direction de l'espace intérieur (22) du boîtier (21) dans l'état détendu dans la direction d'empilement (17).

5. Echangeur de chaleur selon l'une quelconque des revendications 1 à 3,
**caractérisé en ce**
**qu'**au moins une section de précontrainte (25) de ce type présente une zone de contact (29) plane s'étendant de manière perpendiculaire par rapport à la direction d'empilement (17) et deux zones élastiques (36), qui sont disposées de part et d'autre de la zone de contact (29) et qui relient la zone de contact (29), par le côté respectif, aux sections de paroi (37), s'étendant de manière parallèle par rapport à la direction d'empilement (17), de la gaine (23).

6. Echangeur de chaleur selon l'une quelconque des revendications 1 à 5,
**caractérisé en ce**
**que** la gaine (23) présente deux sections de paroi (37) s'étendant le long de la direction d'empilement (17), lesquelles se font face de manière transversale par rapport à la direction d'empilement (17).

7. Echangeur de chaleur selon l'une quelconque des revendications 1 à 6,
**caractérisé en ce**
**que** le boîtier (21) est divisé en un plan de division (38) s'étendant de manière perpendiculaire par rapport à la direction d'empilement (17) et présente une partie supérieure (39) ainsi qu'une partie inférieure (40), au moins une desdites parties (39, 40) présentant au moins une section de précontrainte (25) de ce type.

8. Echangeur de chaleur selon l'une quelconque des revendications 1 à 7,
**caractérisé en ce**
**que** la section de précontrainte (25) respective s'étend dans la direction longitudinale (19) du boîtier (21) essentiellement sur toute la longueur de la pile de tubes (18).

9. Echangeur de chaleur au moins selon la revendication 6,
**caractérisé en ce**
**que** la gaine (23) présente dans la zone de la section de précontrainte (25) respective une épaisseur de paroi (41), qui est plus grande qu'une épaisseur de paroi (42), que la gaine (23) présente dans la zone de la section de paroi (37) respective.

10. Echangeur de chaleur au moins selon la revendication 6,
**caractérisé en ce**
**que** la gaine (23) est fabriquée dans la zone de la section de précontrainte (25) respective à partir d'un matériau autre que dans la zone de la section de paroi (37) respective.

11. Echangeur de chaleur selon l'une quelconque des revendications 1 à 10,
**caractérisé en ce que**
le tube de chauffage (15) respectif et/ou le tube de refroidissement (16) respectif présentent, dans leur intérieur, une structure de support (43), qui rigidifie le tube (15, 16) respectif dans la direction d'empilement (17).

12. Echangeur de chaleur selon l'une quelconque des revendications 1 à 11,
**caractérisé en ce**
**qu'**au moins une plaque de renforcement (44) est disposée, dans la direction d'empilement (17), entre la gaine (23) et la pile de tubes (18).

13. Moteur à combustion interne, en particulier d'un véhicule automobile,
- comprenant un bloc moteur (2), qui présente plusieurs compartiments de combustion (3)
- comprenant un système de gaz d'échappement (5) servant à évacuer des gaz d'échappement de combustion (10) des compartiments de combustion (3),
- comprenant un circuit de refroidissement (6) servant à refroidir le bloc moteur (2),
- comprenant un échangeur de chaleur (9) selon l'une quelconque des revendications 1 à 12, dont les tubes de chauffage (15) sont couplés de manière fluidique au système de gaz d'échappement (5) et dont les tubes de refroidissement (16) sont couplés de manière fluidique au circuit de refroidissement (6).
